# EUROPEAN PATENT APPLICATION

(11) **EP 3 493 273 A1**
(43) Date of publication of application: **05.06.2019**
(21) Application number: 17204885.2
(22) Date of filing: 01.12.2017
(51) Int. Cl.: H01L 31/042, H01L 31/048, H01L 31/049, H02S 40/42

(54) **STACKED PHOTOVOLTAIC MODULE ASSEMBLY**

(71) Applicant: SABIC Global Technologies B.V., 4612 PX Bergen op Zoom (NL)
(72) Inventor: Brounne, Marcel, 6160 GA GELEEN (NL)
(74) Representative: Sabic Intellectual Property Group

(57) **Abstract**

The invention relates to a photovoltaic module assembly, comprising an optically transparent top layer comprising a polycarbonate sheet; a thermoplastic backing structure; a photovoltaic layer comprising photovoltaic cells; and an encapsulating layer enclosing the photovoltaic cells, wherein the encapsulating layer and the photovoltaic cells are located between the top layer and the backing structure, and wherein the encapsulating layer comprises a thermoplastic polyurethane.

## Description

### BACKGROUND OF THE INVENTION

### Field of the Invention

The present invention relates to a photovoltaic module assembly, comprising a top layer with a polycarbonate sheet, a backing structure and a photovoltaic layer between the top layer and the backing structure.

### Description of the Related Art

A photovoltaic module assembly, or a solar panel, usually comprises a front sheet, generally made from a transparent or translucent material, that covers one or more of a string of photovoltaic cells or solar cells. PV module assemblies generally further comprise a frame, a junction box, cables, connectors, a ground fault circuit interrupter (GFCI), a mounting system, a backing structure, encapsulant layers, photovoltaic (PV) cells, an anti-reflective layer, and a front layer of glass. The frame, when present, is generally made of aluminum. The aluminum frame and the glass front layer, possibly in combination with a glass backing layer, are the biggest contributors to the weight of the PV module assemblies, which can make the assemblies generally heavy and expensive to produce. Glass accounts for the largest part of the weight of a PV module assembly.

Accordingly, there is a need for PV module assemblies with one or more of decreased weight, reduced assembly times, and increased production rates, while maintaining the desired mechanical and/or electrical performance properties, at similar or lower cost of a standard glass and aluminum module.

### BRIEF SUMMARY OF THE INVENTION

According to the invention, there is provided a photovoltaic module assembly comprising:
an optically transparent top layer comprising a polycarbonate sheet;
a thermoplastic backing structure;
a photovoltaic layer comprising photovoltaic cells; and
an encapsulating layer enclosing the photovoltaic cells, wherein the encapsulating layer and the photovoltaic cells are located between the top layer and the backing structure, and wherein the encapsulating layer comprises a thermoplastic polyurethane.

When a polymeric or thermoplastic material is instead used as the material for the front sheet, the mechanical properties and/or the optical efficiency of the PV assembly can be decreased. For example, for forming the collector, the polymer poly(methyl methacrylate) is good for light transmission (i.e., high optical efficiency), but lacks sufficient mechanical properties. Polycarbonate has good mechanical properties for producing a flat sheet, but has a lower optical efficiency. Using a thermoplastic material such as polycarbonate for the top layer can allow for the incorporation of optical textures such as Fresnel lenses to increase the amount of light captured. Incorporating features such as triangles on a surface of the top layer adjacent to the photovoltaic layer can capture light between the PV cells that would normally be lost.

When the glass is replaced with a polycarbonate sheet, laminate or structure, the resulting PV module assembly results in a much lighter assembly (e.g., less than or equal to 10 kilograms per square meter (kg/m²), specifically less than or equal to 5 kg/m², for assemblies without glass as compared to 13 kg/m² for assemblies with glass), which can allow for placement on roofs having limited load bearing capacity (e.g., flat roofs).

The PV module assembly according to the invention can be used in solar power generation applications in various manners such as building facades, on rooftops (such as a skylight or roofing tile), in highway/railroad sound barriers, greenhouses, dual purpose window glazing, and commercial buildings.

The PV cell converts the light energy into electrical energy. Several different types of PV cells can be used. Suitable bulk technology PV cells include polycrystalline silicon cells or monocrystalline silicon cells. Suitable thin film technology PV cells include amorphous silicon cells, cadmium telluride cells (CdTe), copper indium selenide cells, gallium arsenide or indium selenide cells, copper indium gallium selenide cells (CIGS), and organic cells, as well as combinations thereof.

A PV cell as used in the photovoltaic (PV) module assembly can be formed of layers of p-i-n semi-conductive material. Optionally, each layer of which can, in turn, be formed of, a semiconductor alloy material (e.g., a thin film of such alloy material). In one embodiment, a p-i-n type PV device, such as a solar cell, can comprise individual p-i-n type cells. Below the lowermost cell can be a substrate (e.g., a transparent substrate) or a substrate comprising a metallic material such as stainless steel, aluminum, tantalum, molybdenum, chrome, or metallic particles embedded within an insulator (cermets). In some applications there is a thin oxide layer and/or a series of base contacts prior to the deposition of the amorphous semiconductor alloy material.

Each of the cells can be fabricated from a body of thin film semiconductor alloy material comprising silicon and hydrogen. Each of the bodies of semiconductor alloy material includes an n-type layer of semiconductor alloy material; a substantially intrinsic layer of semiconductor alloy material; and a p-type layer of semiconductor alloy material. The intrinsic layer can include traces of n-type or p-type dopant material without forfeiting its characteristic neutrality, hence it may be referred to as a "substantially intrinsic layer". Also, although p-i-n type photovoltaic cells are described, the methods and materials can also be used to produce single or multiple n-i-p type solar cells, p-n type cells or devices, Schottky barrier devices, as well as other semiconductor elements and/or devices such as diodes, memory arrays, photoresistors, photodetectors, transistors, etc. The term "p-i-n type", as used herein, is defined to include any aggregation of n, i, and p layers operatively disposed to provide a photoresponsive region for generating charge carriers in response to absorption of photons of incident radiation.

Generally, each type of PV cell has a "sweet spot", or a range of wavelengths (light energy), which it converts most efficiently into electric energy. The PV cell should be selected so that its sweet spot matches, as much as possible, the transmitted light through the optional coating, top layer, and encapsulating layer combination. For example, the sweet spot of a polycrystalline silicon photocell or a monocrystalline silicon PV cell is 700 nanometers to 1100 nanometers. The PV cell can be selected such that it can harvest UV light with a wavelength of 200 to 400 nm.

The efficiency of a PV cell can be affected by the way the cell is produced. Generally, it is desirable for the PV cell to have smooth edges and faces rather than rough edges and faces. The size (e.g., length and width) and shape of the PV cells can vary. Shapes can include various polygonal designs such as square, rectangular, and so forth. The length and width can, individually be up to 200 mm, specifically, 100 mm to 175 mm. Preferably, the size of the individual PV cells in the module is, for example, 125 by 125 mm, or 156 by 156 mm.

The encapsulating layer can additionally aid in transporting heat out of the PV cells to the atmosphere, resulting in higher efficiency for the PV module over time. The material for the encapsulating layer can be selected so that is suffices a number of requirements, such as transparency and high transmission, and a refractive index (RI) close to that of the material(s) used for the top layer, as the encapsulating layer is adjacent to the top layer. Having the refractive index (RI) of this layer close in value to the RI of the top layer limits the light lost between the encapsulating layer and the top layer and further increasing the efficiency of the PV module. For example, the RI of PC is 1.58 and the RI of a TPU is 1.50. The refractive index of the material of the top layer can be within 15% of the refractive index of the material of the encapsulating layer.

According to an embodiment, the backing structure comprises a thermoplastic first backing layer, a thermoplastic second backing layer, and a thermoplastic support layer located between the first backing layer and the second backing layer, wherein the support layer comprises stiffening elements to reinforce the backing structure.

Replacing glass with polycarbonate also generally results in a reduction in mechanical properties (e.g. stiffness and/or flexural strength) of the overall assembly. It was unexpectedly discovered that when a support layer is incorporated into the backing structure, the mechanical properties of the PV module assembly could be increased without significantly increasing its weight.

The stiffening element may comprise a vertical stiffening element, a horizontal stiffening element, a diagonal stiffening element, or a combination comprising one or more of the foregoing. For example, the support layer or the backing structure may comprise a multiwall sheet, wherein the internal walls function as the stiffening members and the sandwiching layers form the first backing layer and the second backing layer. Additionally, the channels in the multiwall sheet may additionally aid in transporting heat out of the PV module to the atmosphere through convection. Alternatively, the multiwall sheet forms the support layer and separate first and second backing layers are provided at each major opposite side of the multiwall sheet. The support layer may have a thickness of 1 to 35 mm, specifically 10 to 25 mm, and more specifically, 12, 16 or 20 mm thick (as measured in the y direction). The support layer can be located between the first and second backing layers such that the thickness of the backing structure may be 2 to 60 mm, specifically 5 to 40 mm, even more specifically 10 to 25 mm thick. A combined thickness of the first and second backing layers can be less than or equal to 1 mm thick.

The support layer can comprise one or more of the polymers previously described with respect to the top layer, backing structure, the first backing layer and/or the second backing layer, as well as one or more of the previously described additives. Specifically, the support layer can comprise polypropylene, polyethylene, polystyrene, polyethylene terephthalate, polyamide, polycarbonate, acrylonitrile-butadiene-styrene, acrylonitrile-styrene-acrylonitrile, polyurethane, polyphenylene sulfide, polyetherimide, poly(*p*-phenylene oxide) or poly(*p*-phenylene ether) (PPE), or a combination comprising one or more of the foregoing.

The backing structure can additionally comprise an integrated assembly including the junction box, cables, controllers, and mounting points, meaning that the production time and assembly time of the PV module assembly can be decreased.

According to an embodiment, the first backing layer, the support layer and/or the second backing layer comprise a polycarbonate, an acrylonitrile-styrene-acrylonitrile copolymer, a polycarbonate-acrylonitrile-styrene-acrylonitrile copolymer, poly(phenylene oxide), polypropylene, or a combination comprising one or more of the foregoing. Preferably, at least one or the first backing layer and the second backing layer comprises a polycarbonate sheet, and/or the support layer comprises polycarbonate. For instance, the backing layer is a polycarbonate multiwall sheet.

It is desirable that at least the top layer has certain optical properties to allow the photovoltaic cells to work optimally. Additionally, the backing structure, e.g. the first or second backing layer, may have certain optical properties as well. For example, while the top layer is optically transparent, the backing structure may be transparent, translucent, or opaque, for instance due to a backing layer being opaque or translucent, or transparent. With regards to the transparency of the various layers, it is briefly noted that end user specifications can generally specify that the various layers satisfy a particular predetermined threshold.

A translucent material allows light to pass through, but does not necessarily (on the macroscopic scale) follow Snell's law; the photons can be scattered at either of the two interfaces where there is a change in index of refraction, or internally. In other words, a translucent material allows the transport of light while a transparent material not only allows the transport of light but allows for image formation. Having said that, the top layer is optically transparent, meaning that it is transparent to at least light visible to the human eye, wherein the transmittance of visible light is above 30%. The top layer can have a transparency of greater than or equal to 80%, specifically, greater than or equal to 85%, more specifically, greater than or equal to 90%, even more specifically, greater than or equal to 95%, and still more specifically, greater than or equal to 99%, as measured in accordance with ASTM D1003-00, Procedure A or Procedure B, using lamp D65.

Haze values, as measured by ANSI/ASTM D1003-00, can be a useful determination of the optical properties of one or more of the top layer and backing structure or first and second backing layers. The lower the haze levels, the higher the transparency of the individual layer or structure. It can be desirable to monitor the haze levels of the various layers or structure. Exemplary haze levels for the transparent top layer, when measured at a thickness of 5.0 mm, can be 0% to 6%, specifically 0.5% to 4%, and more specifically 1% to 2.5%. Exemplary haze levels for the first backing layer, when measured at a thickness of 5.0 mm, can be generally greater than 6%, specifically, greater than or equal to 10%.

The first and/or second backing layer can be translucent, but can also be transparent or opaque if desired, for example, for aesthetic reasons. For example, the first and/or second backing layer can have a transparency of greater than or equal to 50%, specifically, greater than or equal to 65%, more specifically, greater than or equal to 75%, and even more specifically, greater than or equal to 90%. Transparency is described by three parameters, percent transmission, percent haze, and clarity. Percent transmission and percent haze for laboratory scale samples can be determined using ASTM D1003-00, Procedure B using CIE standard illuminant C. Haze can also be measured in accordance with ASTM D-1003-00, Procedure A.

According to an embodiment, the encapsulating layer comprises a first encapsulant layer of thermoplastic polyurethane (TPU) adjacent and bonding to the top layer, and a second encapsulant layer of an encapsulant material different from thermoplastic polyurethane, adjacent and bonding to the first encapsulant layer and the backing structure.

The first encapsulant layer may suffice a number of requirements, such as transparency and high transmission, and a refractive index close to that of the material(s) used for the top layer, as this first encapsulant layer is adjacent to the top layer. The second encapsulant layer may suffice the same or other requirements, as the second encapsulant layer is not adjacent to the top layer, but to the first encapsulant layer and the backing structure. The second encapsulant layer can comprise an encapsulant material different from TPU, such as a cured composition, polyethylene glycol (PEG), including polyethylene oxide (PEO) or polyoxyethylene (POE), polyvinyl butyral (PVB) and/or ionomers. The cured composition can be one that is thermally cured, cured by ultraviolet (UV) radiation, catalyst cured, or can naturally cure when one or more reactive monomers are present. The cured composition can comprise, for example, poly(ethylene vinyl acetate) (EVA), a curable silicone (such as a silicone thermoset elastomer (TSE), a UV curable silicone, or a room temperature vulcanize (RTV) silicone), and combinations comprising at least one of the foregoing.

Generally, PV modules comprise a top layer made of glass that can function to impart rigidity to the module and a back layer, where the material of the back layer generally does not function to impart rigidity to the module. Typically, the glass top layer is 3.2 millimeters (mm) thick. As described herein, the glass top layer can be replaced with a layer comprising a thermoplastic material that can result in significant weight savings for the PV module assembly. The thickness of the top layer, the first backing layer, and the second backing layer can be, individually, 0.5 to 25 mm, specifically, 0.8 to 8 mm, even more specifically, 1 to 3.2 mm, specifically, 1 to 1.5 mm. The thickness of the top layer, and the first and second backing layers can be the same or different. The thickness of the top layer may range from 0.8 to 1.5 mm, preferably 1 mm.

The photovoltaic module assembly may further comprise a connector connecting the top layer to the backing structure, wherein the connector is provided between the top layer and the backing structure.

The connector can be formed (e.g., molded) as part of either the top layer or the backing structure, e.g. the first backing layer, or the connector can be a separate piece provided between the top layer and the backing structure, e.g. the first backing layer. The connector can be welded (e.g. fusion welded or laser welded) to the top layer and/or the first backing layer. The connector can be any adhesive having sufficient structural integrity and compatibility with the top layer and the backing structure or first backing layer to inhibit delamination.

The connector can act to form a gap between the top layer and the backing structure, e.g. the first backing layer, into which the encapsulating layer can be inserted (e.g., poured). The connector can have a thickness of 0.5 to 10 millimeters (mm), or, more specifically, 1.0 to 5.0 mm, and even more specifically, 2.5 to 3.5 mm. The connector can have a width that is less than or equal to 50% of a total surface area of the layer (e.g., the layer to which it is applied), or, more specifically, 1% to 40% of the total surface area, and, yet more specifically, 2% to 20% of the total surface area. The connector can be located in an edge region covering the outer 40% of the top layer and/or the first backing layer (measuring from an edge of the respective layer toward a center of the respective layer), or, more specifically, in the outer 25%, and yet more specifically, in the outer 10%. For example, if the layer has a width of 1.0 meter (m), the connector could be located between the outer edge and 0.4 m from the outer edge, or, more specifically, between the outer edge and 0.25 m from the outer edge, and yet more specifically, between the outer edge and 0.05 m from the outer edge. Preferably, the connector is located at the edge and extending towards the center of the respective layer.

The top layer and the backing structure, e.g. the first and second backing layer, can be made of or comprise the same or different materials, or can each independently comprise a polymeric material, e.g., a thermoplastic material. As such, the top layer comprises a polycarbonate sheet and possibly a further thermoplastic layer, thus forming a laminate top layer.

The thermoplastic material can comprise polymers, copolymers, and combinations comprising at least one of the foregoing having the desired optical properties for a PV application. Examples of such thermoplastic materials include, but are not limited to, polycarbonates (e.g., blends of polycarbonate, and copolycarbonates), polystyrenes (e.g., copolymers of polycarbonate and styrene, acrylonitrile-styrene-butadiene copolymers, and acrylonitrile-styrene-acrylonitrile (ASA) copolymers), poly(phenylene ether)-polystyrene resins, polyalkylmethacrylates (e.g., polymethacrylates, poly(methyl methacrylates) (PMMA)), polyesters (e.g., copolyesters, polythioesters), polyolefins (e.g., polypropylenes and polyethylenes, high density polyethylenes, low density polyethylenes, linear low density polyethylenes), polyamides (e.g., polyamideimides), polyethers (e.g., polyether ketones, polyether etherketones, polyethersulfones), poly(ethylene)terephthalate (PET), poly(butylene)terephthalate (PBT), and combinations comprising at least one of the foregoing.

More particularly, the thermoplastic material used in one or more of the top layer, the first backing layer, or the second backing layer can include, but are not limited to, polycarbonate resins (e.g., LEXAN™ resins, commercially available from SABIC's Innovative Plastics business), poly(methyl methacrylate resins, polyphenylene ether-polystyrene resins and/or polyphenylene oxide resins (e.g., NORYL™ resins, commercially available from SABIC's Innovative Plastics business), polyetherimide resins (e.g., ULTEM™ resins, commercially available from SABIC's Innovative Plastics business), polybutylene terephthalate-polycarbonate resins (e.g., XENOY™ resins, commercially available from SABIC's Innovative Plastics business), copolyestercarbonate resins (e.g. LEXAN™ SLX resins, commercially available from SABIC's Innovative Plastics business), polypropylene resins (e.g. 83MF10-10200, commercially available from SABIC's Innovative Plastics business) and combinations comprising at least one of the foregoing resins. Even more particularly, the thermoplastic resins can include, but are not limited to, homopolymers and copolymers of: a polycarbonate, a polyester, a polyacrylate, a polyamide, a polyetherimide, a polyphenylene ether, or a combination comprising at least one of the foregoing resins. The polycarbonate can comprise copolymers of polycarbonate (e.g., polycarbonate-polysiloxane, such as polycarbonate-polysiloxane block copolymer), linear polycarbonate, branched polycarbonate, end-capped polycarbonate (e.g., nitrile end-capped polycarbonate), and combinations comprising at least one of the foregoing, for example a combination of branched and linear polycarbonate.

Besides the polycarbonate sheet, the top layer can comprise a further layer of poly(methyl methacrylate), polycarbonate, or a combination comprising one or both of the foregoing and the first and second backing layers can each independently comprise an, poly(phenylene oxide)/polystyrene blend, polycarbonate, polyester, PET or PBT, polypropylene, or a combination comprising one or more of the foregoing. For example, the top layer comprises a polycarbonate and the first and second backing layers can comprise an acrylonitrile-styrene-acrylonitrile copolymer.

One or more of the top layer, and the backing structure, e.g. the first and second backing layers, can include various additives ordinarily incorporated into polymer compositions of this type, with the proviso that the additive(s) are selected so as to not significantly adversely affect the desired properties of the PV module assembly, in particular, energy yield and weight savings.

Examples of additives that can be included in the materials used to make the various layers of the PV module assembly include, but are not limited to, optical effects filler, impact modifiers, fillers, reinforcing agents, antioxidants, heat stabilizers, light stabilizers, ultraviolet (UV) light stabilizers, plasticizers, lubricants, mold release agents, antistatic agents, colorants (such as titanium dioxide, carbon black, inorganic dyes, and organic dyes), surface effect additives, radiation stabilizers (e.g., infrared absorbing), gamma stabilizer, flame retardants, and anti-drip agents, and combinations thereof. In general, the additives are used in the amounts generally known to be effective. Each of these additives can be present in amounts of 0.0001 to 10 weight percent (wt.%), specifically 0.001 to 5 wt.%, based on the total weight of the layer in which the additive is incorporated.

One or more of the top layer, the backing structure and/or the first and second backing layers can optionally comprise a flame retardant or a fire resistant layer. Preferably, the backing structure is provided with a fire-resistant layer at a side opposite of the top layer. Flame retardants include organic, inorganic materials, and/or an intumescent layer that swells as a result of heat exposure during a fire or starting fire, thus increasing in volume and decreasing in density and form a charred barrier to heat propagation in case of fire.

Organic compounds include, for example, phosphorus, sulphonates, and/or halogenated materials (e.g., comprising bromine chlorine, and so forth, such as brominated polycarbonate). Inorganic flame retardants include, for example, C₁₋₁₆ alkyl sulfonate salts such as potassium perfluorobutane sulfonate (Rimar salt), potassium perfluorooctane sulfonate, tetraethyl ammonium perfluorohexane sulfonate, and potassium diphenylsulfone sulfonate (e.g., KSS); salts such as Na₂CO₃, K₂CO₃, MgCO₃, CaCO₃, and BaCO₃, or fluoro-anion complexes such as Li₃AlF₆, BaSiF₆, KBF₄, K₃AlF₆, KAlF₄, K₂SiF₆, and/or Na₃AlF₆. When present, inorganic flame retardant salts are present in amounts of 0.01 to 10 parts by weight, more specifically 0.02 to 1 parts by weight, based on 100 parts by weight of the total composition of the layer of the PV module assembly in which it is included (i.e., the top layer, the backing structure or the first or second backing layer), excluding any filler.

Anti-drip agents can also be used in the composition forming one or more of the first, second, and third layers, for example a fibril forming fluoropolymer such as polytetrafluoroethylene (PTFE). The anti-drip agent can be encapsulated by a rigid copolymer, for example styrene-acrylonitrile copolymer (SAN). PTFE encapsulated in SAN is known as TSAN. An exemplary TSAN comprises 50 wt.% PTFE and 50 wt.% SAN, based on the total weight of the encapsulated fluoropolymer. The SAN can comprise, for example, 75 wt.% styrene and 25 wt.% acrylonitrile based on the total weight of the copolymer. Anti-drip agents can be used in amounts of 0.1 to 10 parts by weight, based on 100 parts by weight of the total composition of the particular layer, excluding any filler.

One or more of the top layer, and the backing structure and its layers can additionally comprise a silicone hard coat and/or a plasma deposition layer, for example, on the outermost surface of the top layer and/or the backing structure, e.g. the second backing layer, to potentially ensure a 20-year lifetime span for the PV module assembly. One or more of the top layer and backing structure can also desirably have an ultraviolet light stability of 20 years such that they retain greater than or equal to 80% of their light transmission capabilities over that 20-year period.

Turbulent airflow, which functions to cool the PV module, can be created by aerodynamic features integrated in the backing structure. The top layer can also, optionally, be textured to decrease light reflection. Both the turbulent air flow and the texturing can provide higher energy yield during a PV module's lifetime under different circumstances, such as sunlight entering at an angle, high ambient temperatures, and partial shading of the PV module. For example, the aerodynamic features can include, but are not limited to fins, ribs, baffles, and combinations comprising at least one of the foregoing. Turbulent air flow and texturing, when integrated into a PV module can reduce cost, decrease production times, and reduce the weight of the PV module as well as optimize the yield of a system during its useful lifetime.

According to an embodiment, the thickness of the photovoltaic layer can be 0.1 to 1 mm, specifically, 0.2 to 0.5 mm. The encapsulating layer can be 0.5 to 10 mm thick, preferably 0.7 to 5 mm, and even more specifically, 1.0 to 2.0 mm.

The overall size of the module is a function of the process used to make the module, such as injection molding. The overall size of the module can be, for example, 1 by 1 meter (m) or 1 by 2 m, or 1 by 6 m, typically 1 by 1.7 m.

According to an embodiment, the top layer further comprises a protective cap layer on a side of the polycarbonate sheet facing away from the encapsulating layer.

The protective cap layer can be an ultraviolet radiation absorbing layer and/or a scratch resistant layer. Preferably, the protective cap layer is a co-extruded polycarbonate layer with a UV absorbing component, for instance with a UV absorbing additive. The thickness of the protective cap layer can be in the range of 1 to 100 micrometer, preferably in the range of 40 to 60 micrometer. Alternatively, or additionally, the co-extruded layer may be a PMMA layer on the polycarbonate sheet of the top layer.

The PV module can also comprise a top layer having a coating dispersed on the outermost surface of the top layer, e.g., a silicone hard coat and/or a plasma coating, specifically for a polycarbonate sheet. The plasma coating (e.g., EXATEC™ E900 coating, commercially available from EXATEC LLC) can help to ensure the PV module can function for a certain period of time, e.g., 20 years. When one of the layers comprises, for example, polycarbonate, said layer can comprise planarizing layer(s) and/or organic-inorganic composition barrier coating layer(s) which can include a silicone hard coat and/or a plasma treatment process. For example, the barrier coating can have optical properties that are substantially uniform along an axis of light transmission, said axis oriented substantially perpendicular to the surface of the coating. The planarizing layer can comprise a resin such as an epoxy based resin (cycloaliphatic resin), an acrylic based resin, a silicone resin, as well as combinations comprising at least one of the foregoing. In some embodiments, the planarizing layer thickness can be 1 nanometer (nm) to 100 micrometers (µm). Often the planarizing layer thickness can be 100 nm to 10 µm, specifically, 500 nm to 5 µm.

The planarizing layer can be substantially smooth and substantially defect free. The term "substantially smooth" means the average surface roughness Rₐ is less than or equal to 4 nm, specifically, less than or equal to 2 nm, and more specifically, less than or equal to 0.75 nm. The peak surface roughness Rₚ can be less than or equal to 10 nm, specifically less than or equal to 7 nm, and more specifically, less than or equal to 5.5 nm. The term "average surface roughness" Rₐ is defined as the integral of the absolute value of the roughness profile measured over an evaluation length. The term "peak surface roughness" Rₚ is the height of the highest peak in the roughness profile over the evaluation length.

Substantially defect free means the number of point defects is less than or equal to 100 per square millimeter (/mm²), specifically, less than or equal to 10/mm², and more specifically, 1/mm². Alternatively, one or more of the first, second, and third layers can be free of a coating.

The PV module assembly disclosed herein can be designed to weigh approximately 5 kg/m² compared to 13 kg/m² for PV modules containing a glass top layer and/or aluminum frame. The layers of the PV module can be formed from a thermoplastic composition by a variety of techniques such as casting, injection molding, extrusion, rotational molding, blow molding, and thermoforming. As a result, the assembly time for the PV module can decrease from greater than or equal to 20 minutes to 1 minute to 5 minutes, specifically, 2 minutes to 3 minutes. Installation of the PV module assembly can be easier and less time consuming since the PV module is lighter and as mentioned, incorporates integrated mounting points which allow for easy installation. Additionally, the use of micro-inverters can allow the system to be a plug and play without the need for a separate inverter installation step. The overall cost of the PV module assembly can be decreased by 10% due to the faster assembly time and shorter installation time partly because of the integration of the junction box and inverter. One or more of the first, second, and third layers can be reground and reused in a new layer or structural support part.

### BRIEF DESCRIPTION OF THE DRAWINGS

The following is a brief description of the drawings wherein like elements are numbered alike and which are presented for the purposes of illustrating the exemplary embodiments disclosed herein and not for the purposes of limiting the same.
Figure 1 shows a perspective view of a photovoltaic module assembly according to the invention.
Figure 2 shows a cross-sectional side view of an embodiment of a PV module assembly.
Figure 3 shows a cross-sectional view of another embodiment of a PV module assembly.
Figure 4 shows a cross-section of the PV module of Fig. 3 along line A-A.

### DETAILED DESCRIPTION

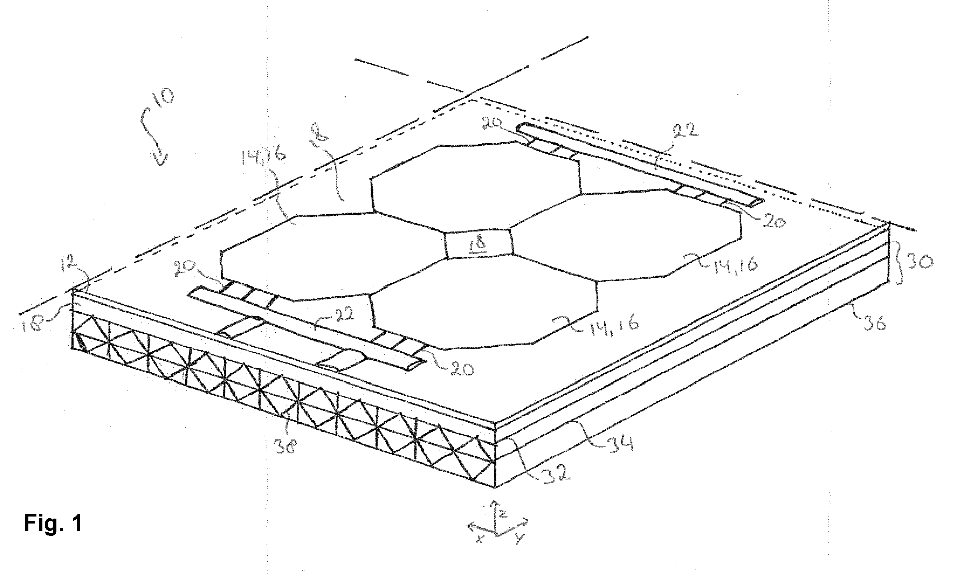

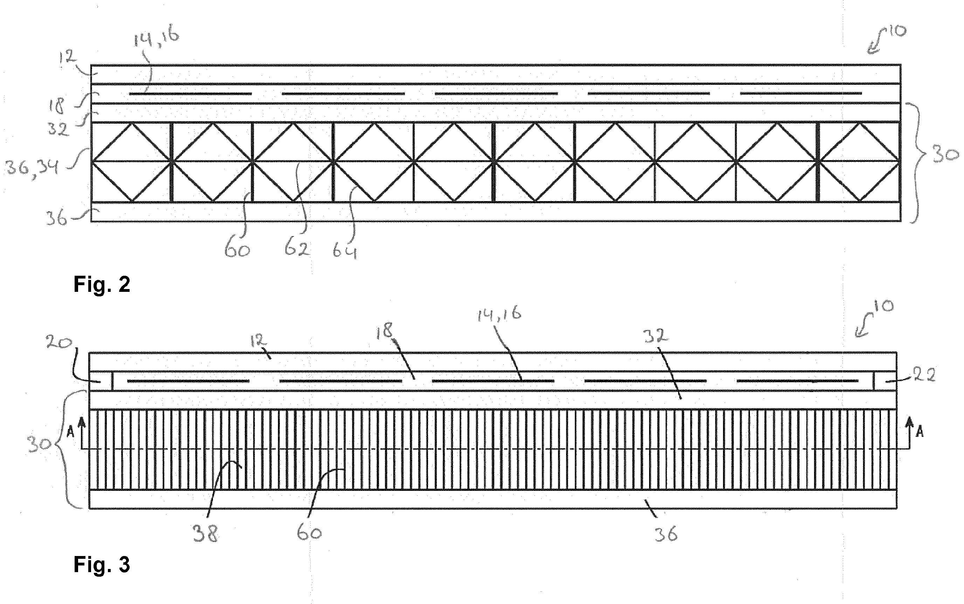

Figure 1 illustrates a perspective schematic view of the individual components of a photovoltaic (PV) module 10, wherein the PV module 10 comprises a top layer 12; a photovoltaic layer 14 comprising PV cells 16; an encapsulating layer 18 and a backing structure 30 that comprises a first backing layer 32, a support layer 34, and a second backing layer 36, see also figures 2 and 3. The PV cells 16 are connected through wiring 20 to bus bars 22, that further connect to an external collector (not shown).

The backing structure 30 can comprise a frame, a junction box, cables, connectors, mounting points for mounting to an external structure, and an inverter (e.g., a micro-inverter). Integration of all of these components into the back layer 30 can offer significant savings in production time, assembly time, and cost compared to a PV module where each component is produced separately and has to be assembled after production.

The support layer 34 is added to the backing structure 30 of the PV module 10 in order to increase the mechanical properties of the PV module when the glass top layer is replaced with the top layer comprising a polycarbonate sheet.

The support layer 30 comprises stiffening elements 38 configured to improve the stiffness and/or impact properties of the PV module 10. As shown in Fig. 1, the stiffening element comprises vertical stiffening elements 60 which extend in a z-direction, horizontal stiffening elements 62 which extend in an x-direction, and diagonal stiffening elements 64 which extend between a z- and x-direction. The backing structure shown in figs. 1 and 2 is made of a multiwall sheet having 3 horizontal walls, where two of these horizontal walls are the first and second backing layer, and an X-structure. Preferably, a so-called 5 wall - X structure made of polycarbonate is used as backing structure, which has similar stiffness properties to a 4 mm thick glass front sheet in both the x- and y-directions, with respect to its relatively low weight, namely 2.7 kg per square meter.

The top layer 12 of the PV module 10 comprises a laminate of a polycarbonate sheet 24 with a protective cap layer 26

The PV module 10 of Fig. 1 shows a string of four PV cells 14 in a 2 by 2 matrix arrangement, but depending on the dimensions of the PV module and the individual PV cells, the string can include a multitude of PV cells in one module assembly.

Figure 2 shows a cross-sectional side view of an embodiment of a PV module assembly 10. The encapsulating layer 18 encloses the PV cells 14 of the PV layer 16 and is adjacent to the top layer 12 and the backing structure 30. The encapsulating layer is preferred to bond to the top layer 12 and the backing structure 30, such that a further adhesive between these layers can be omitted. The encapsulating layer 18 of the embodiment of Fig. 1 is a thermoplastic polyurethane (TPU), for instance Estane® AG8451 TPU commercially available from Lubrizol Advanced Materials, Inc. Any used encapsulant material, which this TPU is, is preferred to have a high strain modulus, preferably above 100% elongation, a high light transmittance, preferably at least 80%, more preferred 85-95%, a refractive index equal or lower than the polymeric material(s) used in the top layer, and adheres to the top layer. The TPU used for this embodiment adheres to polycarbonate, which is advantageous as the top layer comprises a polycarbonate sheet, and the first backing layer is a polycarbonate sheet.

Figure 3 shows a cross-sectional view of another embodiment of a PV module assembly. This embodiment comprises similar elements as the embodiment of Fig. 2, but now comprises connectors 20, 22 that connect the top layer 12 to the backing structure 30, in particular to the first backing layer 32. The connectors 20, 22 have a thickness similar to the encapsulating layer 18 and PV layer 16 together.

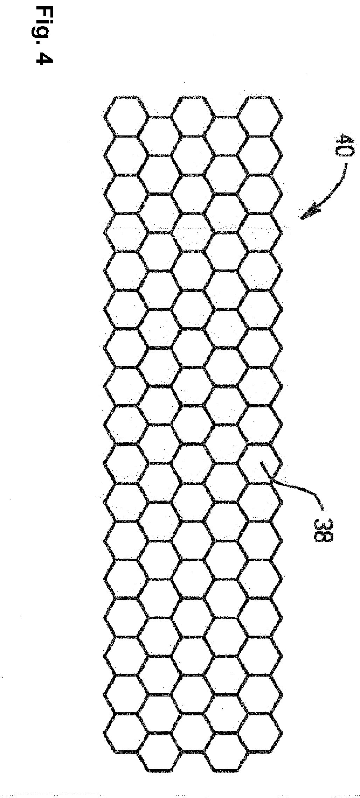

The backing structure 30 further comprises a support layer 34 with stiffening elements 36 that form a honeycomb or alveolar structure, see Figure 4. The stiffening elements comprises vertical stiffening members 60 that form honeycomb shaped channels that extend between the first backing layer 32 and the second backing layer 36.

Figure 4 shows a cross-section of the PV module of Fig. 3 along line A-A. This cross-section shows the hexagonal cross-section of the honeycomb channels 40 of the support layer 34 in Fig. 3. The walls of the hexagonal shaped channels form the stiffening elements 38 of the support layer 34.

## Claims

1. A photovoltaic module assembly (10), comprising:
an optically transparent top layer (12) comprising a polycarbonate sheet;
a thermoplastic backing structure (30);
a photovoltaic layer (16) comprising photovoltaic cells (14); and
an encapsulating layer (18) enclosing the photovoltaic cells, wherein the encapsulating layer and the photovoltaic cells are located between the top layer and the backing structure, and wherein the encapsulating layer comprises a thermoplastic polyurethane.

2. Photovoltaic module assembly according to claim 1, wherein the backing structure comprises a thermoplastic first backing layer (32), a thermoplastic second backing layer (36), and a thermoplastic support layer (34) located between the first backing layer and the second backing layer, wherein the support layer comprises stiffening elements (38) to reinforce the backing structure, and wherein the first backing layer is adjacent to the encapsulating layer.

3. Photovoltaic module assembly according to claim 2, wherein the stiffening element comprises a vertical stiffening element (60), a horizontal stiffening element (62), a diagonal stiffening element (64), or a combination comprising one or more of the foregoing.

4. Photovoltaic module assembly according to claim 2 or 3, wherein the support layer has a thickness of 1 to 35 mm.

5. Photovoltaic module assembly of any of claims 2-4, wherein the first backing layer and/or the second backing layer comprise a polycarbonate, an acrylonitrile-styrene-acrylonitrile copolymer, a polycarbonate-acrylonitrile-styrene-acrylonitrile copolymer, poly(phenylene oxide), polypropylene, or a combination comprising one or more of the foregoing.

6. Photovoltaic module assembly of any of claims 2 to 5, wherein at least one or the first backing layer and the second backing layer comprises a polycarbonate sheet, and/or the support layer comprises a polycarbonate.

7. Photovoltaic module assembly according to any of the preceding claims, wherein the encapsulating layer comprises a first encapsulant layer of thermoplastic polyurethane adjacent and bonding to the top layer, and a second encapsulant layer of an encapsulant material different from thermoplastic polyurethane, adjacent and bonding to the first encapsulant layer and the backing structure.

8. Photovoltaic module assembly of any of claims 2-7, wherein a thickness of the top layer, the first backing layer, and/or the second backing layer is each independently 0.5 to 25 mm.

9. Photovoltaic module assembly of claim 8, wherein the thickness of the top layer is 1.2 to 1.5 mm.

10. Photovoltaic module assembly of any of the preceding claims, further comprising a connector (20, 22) connecting the top layer to the backing structure, wherein the connector is provided between the top layer and the backing structure.

11. Photovoltaic module assembly of any of the preceding claims, wherein the top layer has one or both of a haze level of 0% to 6% when measured at a thickness of 5.0 mm or a transparency of greater than or equal to 80 as measured in accordance with ASTM D1003-00, Procedure A or Procedure B, using lamp D65.

12. Photovoltaic module assembly of any of the preceding claims, wherein the first backing layer and/or the second backing layer is opaque.

13. Photovoltaic module assembly of any of the preceding claims, wherein the photovoltaic layer has a thickness of 0.5 to 10 mm.

14. Photovoltaic module assembly of any of the preceding claims, wherein the backing layer is provided with a fire-resistant layer at a side opposite of the top layer.

15. Photovoltaic module assembly of any of the preceding claims, wherein the top layer further comprises a protective cap layer on a side of the polycarbonate sheet facing away from the encapsulating layer.
